(19) **Europäisches Patentamt / European Patent Office / Office européen des brevets**

(11) **EP 1 486 986 B1**

(12) **FASCICULE DE BREVET EUROPEEN**

(45) Date de publication et mention
de la délivrance du brevet:
**09.04.2008 Bulletin 2008/15**

(51) Int Cl.:
*G11C 16/10* *(2006.01)*

(21) Numéro de dépôt: **04012393.7**

(22) Date de dépôt: **26.05.2004**

(54) **Memoire flash programmable par mot**

Wortweise programmierbarer Flash-Speicher

Word programmable flash memory

(84) Etats contractants désignés:
**DE FR GB IT**

(30) Priorité: **12.06.2003 FR 0307050**

(43) Date de publication de la demande:
**15.12.2004 Bulletin 2004/51**

(73) Titulaire: **STMicroelectronics SA**
**92210 Montrouge (FR)**

(72) Inventeurs:
• **Leconte, Bruno**
**13790 Rousset (FR)**

• **Cavaleri, Paola**
**13790 Rousset (FR)**
• **Zink, Sébastien**
**13090 Aix en Provence (FR)**

(74) Mandataire: **Marchand, André**
**OMNIPAT,**
**24 Place des Martyrs de la Résistance**
**13100 Aix-en-Provence (FR)**

(56) Documents cités:
**EP-A- 1 134 746          US-A- 5 999 451**
**US-A1- 2001 017 789**

**Description**

La présente invention concerne une mémoire en circuit intégré comprenant une mémoire centrale de type Flash comprenant des cellules mémoire formant des pages pouvant recevoir chacune une pluralité de mots, une mémoire tampon et un séquenceur pour exécuter une instruction d'enregistrement, dans une page cible de la mémoire Flash, d'une suite de mots externes reçue sur une borne d'entrée de la mémoire, en enregistrant tout d'abord la suite de mots externes dans la mémoire tampon.

Une telle mémoire Flash est décrite notamment dans la demande de brevet européen EP 1 111 621 et est commercialisée par la demanderesse sous diverses références de produits.

Comme cela est exposé dans la demande de brevet précitée, les mémoires Flash conventionnelles présentent l'inconvénient que le nombre de cellules mémoire pouvant être simultanément programmées est faible, en raison du courant de programmation élevé que nécessite la programmation, par injection d'électrons chauds, de chaque cellule mémoire. Ainsi, le nombre de mots binaires pouvant être simultanément enregistrés dans une mémoire Flash est faible, et très inférieur au nombre de mots que peut recevoir une page de la mémoire. Pour fixer les idées, le nombre de mots binaires pouvant être enregistré simultanément dans une mémoire Flash est généralement un à deux mots de 8 bits chacun (octets), soit 8 ou 16 cellules mémoire programmées simultanément, tandis qu'une page peut classiquement recevoir 256 mots.

La prévision d'une mémoire tampon permet de simuler un mode de programmation par page, en enregistrant à la volée dans la mémoire tampon une suite de mots reçue, et en programmant ultérieurement la mémoire Flash, d'une manière transparente à l'utilisateur.

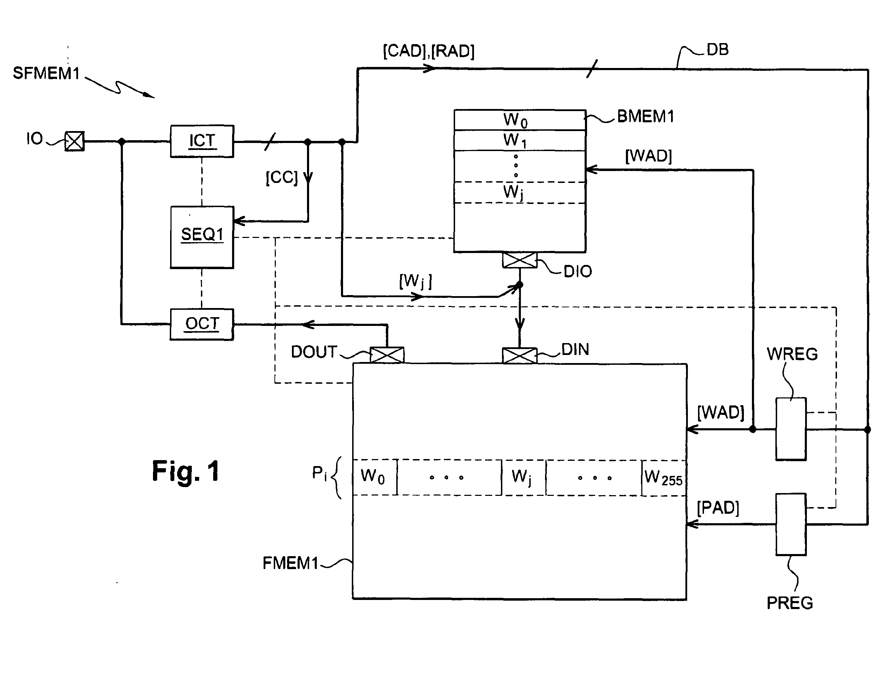

La figure 1 représente schématiquement l'architecture d'une mémoire SFMEM1 du type indiqué ci-dessus.

La mémoire SFMEM1 est ici une mémoire série (serial Flash memory) comprenant une borne d'entrée/sortie série IO, un circuit d'interface d'entrée ICT, un circuit d'interface de sortie OCT, un bus de données parallèle DB, un séquenceur microprogrammé SEQ1, une mémoire tampon BMEM1, une mémoire centrale FMEM1 de type Flash effaçable par secteur et programmable par mot, un registre d'adresse de page PREG et un registre d'adresse de mot WREG. La borne 10 est connectée à l'entrée du circuit ICT et à la sortie du circuit OCT. Le registre WREG est connecté en entrée au bus DB et sa sortie est connectée à une entrée d'adresse de la mémoire FMEM1 (bits de poids faible de l'entrée d'adresse) ainsi qu'à une entrée d'adresse de la mémoire tampon BMEM1. Le registre PREG est connecté en entrée au bus DB et sa sortie est connectée à l'entrée d'adresse de la mémoire FMEM1 (bits de poids fort de l'entrée d'adresse). La mémoire tampon BMEM1 comporte une entrée/sortie de données DIO connectée au bus DB. La mémoire FMEM1 comporte une entrée de données DIN connectée à l'entrée/sortie DIO de la mémoire tampon et une sortie de données DOUT connectée à l'entrée du circuit d'interface OCT.

Le circuit ICT transforme des données série reçues sur la borne IO en données parallèles appliquées sur le bus DB, tandis que le circuit OCT transforme des données parallèles lues dans la mémoire FMEM1 en données série appliquées sur la borne IO. Les données entrantes comprennent des codes commande (lecture, écriture), des adresses, et des mots à enregistrer dans la mémoire Flash.

Une opération d'écriture d'une suite de mots dans une page déterminée, ou page cible, de la mémoire centrale FMEM1, est obtenue en appliquant à la mémoire une commande d'effacement du secteur dans lequel se trouve la page cible, puis une commande d'écriture de la suite de mots qui se présente par exemple sous la forme suivante :

$$[CC_{PWRITE}]\,[PAD0]\,[WAD0]\,[W0]\,[W1]\ldots[Wn]$$

et comprend un code commande d'écriture de page $CC_{PWRITE}$, l'adresse PAD0 de la page cible Pi, l'adresse WAD0, dans la page cible Pi, du premier mot W0 à enregistrer, le premier mot à enregistrer W0 et les mots suivants W1...Wn.

La commande d'écriture est exécutée par le séquenceur SEQ1, qui contrôle les divers éléments de la mémoire. L'adresse de page PAD est chargée dans le registre PREG et est appliquée sur l'entrée d'adresse de la mémoire FMEM1. L'adresse de mot WAD est chargée dans le registre WREG et est appliquée sur l'entrée d'adresse de la mémoire Flash FMEM1 et sur une entrée d'adresse de la mémoire tampon BMEM1. Les mots reçus W0 à Wn sont enregistrés les uns après les autres dans la mémoire tampon BMEM1, en incrémentant à chaque fois l'adresse de mot WAD. Le temps d'enregistrement dans la mémoire tampon est court et tout se passe pour l'utilisateur comme si le chargement de la suite de mots s'effectuait dans les verrous de programmation d'une mémoire programmable par page. Les mots sont ensuite transférés les uns après les autres (ou par groupe de deux) dans la page cible de la mémoire FMEM1, en une succession d'étapes de programmation contrôlées par le séquenceur qui font intervenir les verrous de programmation et sont transparentes pour l'utilisateur.

Une telle mémoire Flash simulant le mode page offre des facilités d'utilisation qui se rapprochent de celles offertes par les mémoires EEPROM programmable par page.

Toutefois, généralement, une mémoire EEPROM programmable par page est également programmable par mot, car chaque groupe de cellules mémoire formant un mot dans une telle mémoire peut être sélectionné individuellement en effacement au moyen d'un transistor de commande de grille. Ainsi, lorsqu'un mot ou un groupe de mots doit être enregistré dans une mémoire EEPROM, seules les cellules mémoire correspondant à ce mot ou à ce groupe de mots sont effacées.

A l'inverse, dans la mémoire Flash décrite ci-dessus, la page est effacée avant enregistrement des mots présents dans la mémoire tampon, et toutes les données présentes dans la page sont perdues.

Ainsi, avant d'appliquer à la mémoire Flash une commande d'enregistrement d'une suite de mots, l'utilisateur doit faire une lecture complète du secteur afin d'y insérer la suite de mots à modifier, puis réenregistrer la totalité du secteur page par page.

La présente invention vise à pallier cet inconvénient.

Plus particulièrement, la présente invention vise une mémoire Flash qui offre un mode de programmation par mot, c'est-à-dire qui garantisse à l'utilisateur qu'une suite de mots fournie par l'utilisateur sera enregistrée dans la mémoire sans que les autres mots de la page cible ne soient effacés.

Pour atteindre cet objectif, l'idée de la présente invention est d'enregistrer dans la mémoire tampon les mots internes présents dans la page cible, à l'exception de ceux devant être écrasés par les mots externes déjà présents dans la mémoire tampon, et de n'effacer la page qu'après sauvegarde de ces mots internes dans la mémoire tampon.

Une autre idée de la présente invention est d'utiliser une mémoire centrale Flash du type effaçable par page, mettant en oeuvre le procédé d'effacement sélectif de page décrit dans la demande internationale WO 02/41322. Ainsi, lors d'un enregistrement de mot, seule la page cible est effacée au cours de l'étape d'effacement et les données présentes dans les autres pages n'ont pas à être sauvegardées, ce qui permet de réduire considérablement la taille de la mémoire tampon.

Plus particulièrement, la présente invention propose une mémoire en circuit intégré, comprenant une mémoire centrale de type Flash comprenant des cellules mémoire formant des pages pouvant recevoir chacune une pluralité de mots, une mémoire tampon, et un séquenceur pour exécuter une instruction d'enregistrement, dans une page cible de la mémoire Flash, d'une suite de mots externes reçue sur une borne d'entrée de la mémoire, en enregistrant tout d'abord la suite de mots externes dans la mémoire tampon, dans laquelle le séquenceur est agencé pour, après avoir enregistré dans la mémoire tampon la suite de mots externes : enregistrer dans la mémoire tampon des mots internes présents dans la page cible et correspondant, en raison de leur adresse dans la page cible, à des emplacements de mots dans la mémoire tampon n'ayant pas reçu de mots externes, effacer la page cible, et enregistrer dans la page cible effacée les mots présents dans la mémoire tampon, comprenant des mots externes et les mots internes sauvegardés avant effacement de la page cible.

Selon un mode de réalisation, la mémoire centrale Flash est du type effaçable par page, et le séquenceur est agencé pour effacer la page cible sans effacer d'autres pages de la mémoire.

Selon un mode de réalisation, la mémoire tampon comprend des moyens pour ajouter à chaque mot externe enregistré dans la mémoire tampon un bit de priorité ayant une valeur déterminée.

Selon un mode de réalisation, le séquenceur est agencé pour : lire toute la page cible, enregistrer dans la mémoire tampon chaque mot interne lu dans la page cible si le bit de priorité du mot présent dans la mémoire tampon à l'adresse de mot correspondante ne présente pas la valeur déterminée.

Selon un mode de réalisation, la mémoire tampon comprend des moyens pour inhiber l'enregistrement d'un mot interne dans la mémoire tampon lorsqu'une commande d'enregistrement est appliquée à la mémoire tampon, si le bit de priorité du mot présent dans la mémoire tampon à l'adresse de mot visée présente la valeur déterminée.

Selon un mode de réalisation, les bits de priorité présents dans la mémoire tampon sont portés à une valeur logique inverse de la valeur logique déterminée, avant l'enregistrement d'une suite de mots externes dans la mémoire tampon.

Selon un mode de réalisation, la mémoire tampon est effacée avant l'enregistrement d'une suite de mots externes.

Selon un mode de réalisation, la mémoire comprend un circuit d'interface série/parallèle pour recevoir des mots externes à enregistrer dans la mémoire Flash, des adresses, et des commandes d'enregistrement, d'effacement ou de lecture de la mémoire Flash.

Selon un mode de réalisation, la mémoire comprend des registres pour appliquer sur des entrées d'adresse de la mémoire Flash une adresse de la page cible et une adresse de mot, et pour appliquer l'adresse de mot sur une entrée d'adresse de la mémoire tampon.

Selon un mode de réalisation, les mots présents dans la mémoire tampon sont enregistrés individuellement dans la mémoire Flash ou par groupes de deux ou quatre mots.

La présente invention concerne également un procédé d'enregistrement d'une suite de mots externes dans une page cible d'une mémoire de type Flash comprenant des cellules mémoire formant des pages pouvant recevoir chacune une pluralité de mots, comprenant une étape préalable d'enregistrement de la suite de mots externes dans une mémoire tampon, comprenant les étapes suivantes : après avoir enregistré dans la mémoire tampon la suite de mots externes, enregistrer dans la mémoire tampon des mots internes présents dans la page cible et correspondant en raison de leur adresse dans la page cible à des emplacements de mots dans la mémoire tampon n'avant bas reçu de mots externes, effacer la page cible, et enregister dans la page cible effacée les mots présents dans la mémoire tampon, comprenant des mots externes et les mots internes sauvegardés avant effacement de la page cible.

Selon un mode de réalisation, l'effacement de la page cible est effectué sans effacer d'autres pages de la mémoire Flash.

Selon un mode de réalisation, le procédé comprend une étape consistant à ajouter un bit de priorité ayant une valeur déterminée à chaque mot externe enregistré dans la mémoire tampon.

Selon un mode de réalisation, le procédé comprend les étapes suivantes : lire toute la page cible, enregistrer dans la mémoire tampon un mot interne lu dans la page cible si le bit de priorité du mot présent dans la mémoire tampon à l'adresse de mot correspondante ne présente pas la valeur déterminée.

Selon un mode de réalisation, les bits de priorité présents dans la mémoire tampon sont portés à une valeur logique inverse de la valeur logique déterminée, avant l'enregistrement d'une suite de mots externes dans la mémoire tampon.

Selon un mode de réalisation, le procédé comprend l'application, sur des entrées d'adresse de la mémoire Flash, d'une adresse de la page cible et d'une adresse de mot, et l'application de l'adresse de mot sur une entrée d'adresse de la mémoire tampon.

Selon un mode de réalisation, les mots présents dans la mémoire tampon sont enregistrés dans la mémoire Flash par groupes de mots comprenant deux ou quatre mots.

Ces objets, caractéristiques et avantages ainsi que d'autres de la présente invention seront exposés plus en détail dans la description suivante d'un exemple de réalisation d'une mémoire selon l'invention, faite à titre non limitatif en relation avec les figures jointes, parmi lesquelles :

- la figure 1 précédemment décrite représente schématiquement l'architecture d'une mémoire Flash classique programmable par page,
- la figure 2 représente schématiquement l'architecture d'une mémoire Flash selon l'invention, programmable par mot,
- la figure 3 représente schématiquement l'architecture d'une mémoire tampon présente dans la mémoire de la figure 2, et
- la figure 4 représente schématiquement l'architecture d'une mémoire centrale de type Flash présente dans la mémoire de la figure 2.

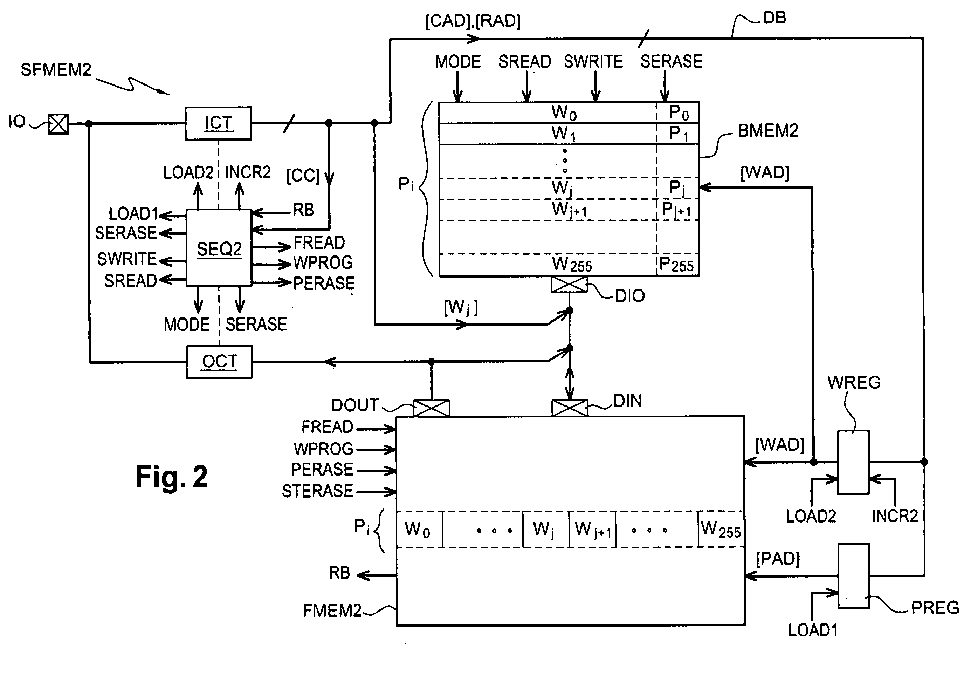

La figure 2 représente schématiquement l'architecture d'une mémoire SFMEM2 selon l'invention, programmable par mot. On entend par "programmable par mot" le fait que, lorsqu'une commande d'écriture d'une suite de mots est appliquée à la mémoire et que la suite de mot comprend un nombre de mot inférieur au nombre de mots que peut recevoir une page, la suite de mots est enregistrée dans la page cible sans perdre les autres données présentes dans la page. Dans une mémoire programmable par page classique comme celle décrite plus haut, une commande d'écriture d'une suite de mots de taille inférieure à celle d'une page est également applicable, mais entraîne la perte des autres données présentes dans la page (Cf. les exemples donnés dans EP 1 111 621).

La mémoire SFMEM2 est une mémoire série intégrée sur une microplaquette de silicium (chip) et comprend une borne d'entrée/sortie série IO, un circuit d'interface d'entrée ICT série/parallèle, un circuit d'interface de sortie OCT parallèle/série, un bus de données parallèle DB, un registre d'adresse de page PREG et un registre d'adresse de mot WREG, ces éléments étant en soi classiques et désignés par les mêmes référence qu'en figure 1. La mémoire SFMEM2 comprend également un séquenceur microprogrammé SEQ2, une mémoire tampon BMEM2, ici de type SRAM, et une mémoire centrale FMEM2 effaçable et programmable électriquement, de type Flash. Le circuit ICT est connecté en entrée à la borne IO et sa sortie est connectée au bus DB. Le circuit OCT est connecté en entrée à une sortie parallèle DOUT de la mémoire FMEM1 et sa sortie est connectée à la borne IO.

Le registre PREG est piloté par un signal de chargement LOAD1 et est connecté en entrée au bus DB. Sa sortie est connectée à une entrée d'adresse de la mémoire FMEM1 (bits de poids fort de l'entrée d'adresse).

Le registre WREG est piloté par un signal de chargement LOAD2 et par un signal d'incrémentation INCR2, et est connecté en entrée au bus DB. Sa sortie est connectée à l'entrée d'adresse de la mémoire FMEM1 (bits de poids faible de l'entrée d'adresse) et sur une entrée d'adresse de la mémoire tampon BMEM1.

La mémoire tampon BMEM1 comporte une entrée/sortie de données DIO connectée au bus DB et la mémoire FMEM1 comporte une entrée de données DIN connectée à l'entrée/sortie DIO de la mémoire tampon.

Selon l'invention, la sortie DOUT de la mémoire FMEM2 est également connectée à l'entrée/sortie DIO de la mémoire tampon.

De préférence, la mémoire FMEM2 est du type effaçable par page et met en oeuvre le procédé d'effacement sélectif de page décrit dans la demande internationale WO 02/41322 (effacement par la source ou par le canal des cellules mémoire, et application d'une tension d'inhibition d'effacement sur les grilles des cellules mémoire appartenant aux pages ne devant pas être effacées). Ainsi, outre une commande d'effacement de secteur STERASE, une commande de lecture FREAD et une commande de programmation de mot WPROG, la mémoire FMEM2 peut également recevoir une commande d'effacement de page PERASE.

La mémoire tampon BMEM2 reçoit une commande d'écriture SWRITE, une commande de lecture SREAD, une commande d'effacement global SERASE. Selon l'invention, la mémoire tampon reçoit également un signal de MODE qui peut présenter une première valeur logique, par exemple 1, correspondant à un mode "USER", et une deuxième valeur logique, par exemple 0, correspondant à un mode "BACKUP". La mémoire tampon comprend à chaque emplacement de mot Wj une cellule mémoire supplémentaire prévue pour recevoir un bit de priorité pj qui est ajouté au mot lors de son enregistrement dans la mémoire tampon, lorsque celle-ci est dans le mode USER, la valeur active du bit de priorité étant par exemple 0.

On suppose ici que chaque page Pi de la mémoire FMEM2 peut recevoir 256 mots W0 à W255. Dans ce cas, la mémoire tampon BMEM2 comprend au moins 256 emplacements mémoire pour recevoir ces mots, chaque emplacement de mot comprenant une cellule mémoire supplémentaire pour recevoir un bit de priorité. En pratique, la mémoire tampon peut présenter d'autres zones mémoire qui ne seront pas décrites ici, destinées par exemple au stockage de données de gestion par le séquenceur SEQ2.

Une commande de programmation d'un mot ou d'une suite de mots dans une page est envoyée à la mémoire sous la forme suivante :

$$[\mathtt{CC_{WWRITE}}]\,[\mathtt{PAD}]\,[\mathtt{WAD}]\,[\mathtt{W0}]\,[\mathtt{W1}]\,.\,.\,.\,[\mathtt{Wn}]$$

et comprend un code commande d'écriture de mots $CC_{WWRITE}$, l'adresse PAD de la page cible, l'adresse WAD, dans la page cible, du premier mot W0 à enregistrer, le premier mot à enregistrer W0 et les mots suivants W1...Wn. Une telle commande est exécutée par le séquenceur SEQ2 conformément au procédé selon l'invention.

Supposons à titre d'exemple qu'une commande d'écriture de deux mots Wj, Wj+1, ayant pour adresses respectives WADj, WADj+1 dans une page Pi d'adresse PADi, soit envoyée à la mémoire :

$$[\mathtt{CC_{WWRITE}}]\,[\mathtt{PADi}]\,[\mathtt{WADj}]\,[\mathtt{Wj}]\,[\mathtt{Wj+1}]$$

Le code commande $CC_{WWRITE}$ est lu par le séquenceur. L'adresse de page PADi est chargée dans le registre PREG et est appliquée sur l'entrée d'adresse de la mémoire FMEM2. L'adresse WADj du premier mot Wj est chargée dans le registre WREG et est appliquée sur l'entrée d'adresse de la mémoire Flash FMEM2 (bits de poids faible) et sur l'entrée d'adresse de la mémoire tampon BMEM2. La mémoire tampon est ensuite effacée. Tous les mots qui s'y trouvent sont ainsi portés à leur valeur effacée, par exemple FF (en notation hexadécimale) et les bits de priorité sont mis à 1 (valeur d'un bit effacée). La mémoire tampon est ensuite placée dans le mode "USER" (MODE=1), et les mots Wj, Wj+1 reçus l'un après l'autre via la borne série IO sont enregistrés dans la mémoire tampon BMEM2 en incrémentant le registre WREG pour que l'adresse appliquée à la mémoire tampon passe de l'adresse WADj à l'adresse WADj+1. A chaque enregistrement d'un mot, le bit de priorité correspondant est mis à 0 (valeur active). La mémoire tampon est ensuite placée dans le mode "BACKUP", le registre d'adresse WREG est mis à 0, la page Pi de la mémoire est lue à commencer par le premier mot W0 et jusqu'au dernier mot W255. Chaque mot lu est fourni sur le bus de données DB et est enregistré dans la mémoire tampon BMEM2 en appliquant la commande SWRITE. A l'intérieur de la mémoire tampon, un circuit logique de contrôle enregistre le mot interne lu dans la page cible si et seulement si le bit de priorité se trouvant à l'adresse correspondante présente la valeur non active (1). Ainsi, lorsque des mots internes d'adresse WADj, WADj+1 sont lus dans la page Pi et que le séquenceur applique la commande d'écriture à la mémoire tampon, ces mots ne sont pas enregistrés par la mémoire tampon car les mots externes Wj, Wj+1 enregistrés en mode USER s'y trouvent. Les bits de priorité correspondants pj, pj+1, qui sont à 0 (valeur active), permettent à la mémoire tampon de savoir que ces mots ne doivent pas être écrasés.

En définitive, tout le contenu de la page Pi se trouve transféré dans la mémoire tampon, à l'exception des mots devant être remplacés par les mots externes Wj, Wj+1 précédemment enregistrés.

La page Pi est ensuite effacée en appliquant une commande PERASE à la mémoire Flash FMEM2, et le contenu de la mémoire tampon BMEM2 est transféré mot à mot dans la mémoire Flash. Les tableaux 1 à 3 ci-après illustrent les étapes qui viennent d'être décrites. Le tableau 1 décrit le contenu de la mémoire tampon après effacement de celle-ci. Le tableau 2 décrit le contenu de la mémoire tampon après chargement des deux mots externes Wj, Wj+1, dont la valeur "EXTVALUE" est comprise entre 00 et FF. Le tableau 3 décrit le contenu de la mémoire tampon après chargement des mots internes présents dans la page Pi, dont la valeur "INTVALUE" est également comprise entre 00 et FF. La mémoire tampon étant transférée dans la mémoire Flash, le tableau 3 représente également le contenu de la page Pi au terme du processus de programmation de la mémoire Flash.

**Tableau 1 (après effacement de la mémoire tampon)**

| Adresse de mot | Mot | Valeur du mot | Bit de priorité |
|---|---|---|---|
| WAD0 | W0 | FF | 1 |
| ... | ... | FF | 1 |
| WADj -1 | Wj -1 | FF | 1 |
| WADj | Wj | FF | 1 |
| WADj +1 | Wj +1 | FF | 1 |
| WADj+2 | Wj+2 | FF | 1 |
| ... | ... | FF | 1 |
| WAD255 | W255 | FF | 1 |

**Tableau 2 (après chargement des mots Wj, Wj+1 en mode USER)**

| Adresse de mot | Mot | Valeur du mot | Bit de priorité |
|---|---|---|---|
| WAD0 | W0 | FF | 1 |
| ... | ... | FF | 1 |
| WADj-1 | Wj -1 | FF | 1 |
| WADj | Wj | EXTVALUE | 0 |
| WADj+1 | Wj+1 | EXTVALUE | 0 |
| WADj+2 | Wj+2 | FF | 1 |
| ... | ... | FF | 1 |
| WAD255 | W255 | FF | 1 |

**Tableau 3 (après sauvegarde de la page Pi en mode BACKUP)**

| Adresse de mot | Mot | Valeur du mot | Bit de priorité |
|---|---|---|---|
| WAD0 | W0 | INTVALUE | 1 |
| ... | ... | INTVALUE | 1 |
| WADj-1 | Wj-1 | INTVALUE | 1 |
| WADj | Wj | EXTVALUE | 0 |
| WADj+1 | Wj+1 | EXTVALUE | 0 |
| WADj+2 | Wj+2 | INTVALUE | 1 |
| ... | ... | INTVALUE | 1 |
| WAD255 | W255 | INTVALUE | 1 |

Le procédé selon l'invention permet donc de simuler le mode de programmation par mot des mémoires EEPROM, et n'est pas destructif vis-à-vis des autres données présentes dans la page cible.

Ce procédé s'applique quel que soit le nombre mots externes. Une instruction d'enregistrement d'une suite de mots peut ne comprendre qu'un seul mot à enregistrer. A l'opposé, la suite de mots externes peut comprendre autant de mots que peut en recevoir la page cible. Dans ce cas, aucune donnée interne présente dans cette page n'est sauvegardée dans la mémoire tampon, puisque tous les mots internes sont écrasés par des mots externes.

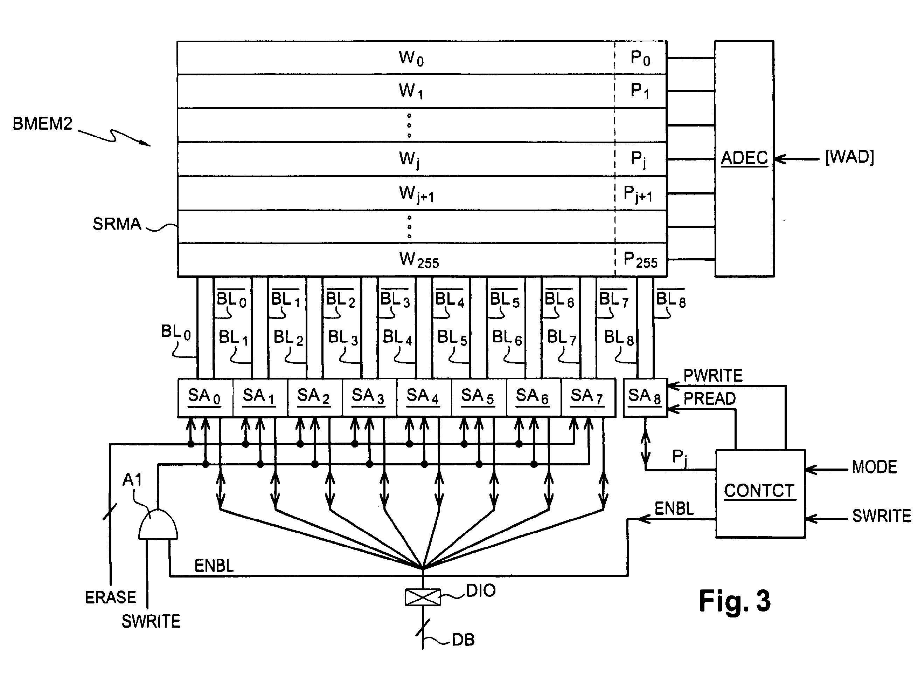

La figure 3 représente un exemple de réalisation de la mémoire tampon BMEM2. La mémoire tampon comprend un plan mémoire SRMA de type SRAM, comprenant 256 lignes de mot pour recevoir les 256 mots d'une page, et 9 lignes de bits pour recevoir les huit bits de chaque mot W0 à W225 ainsi que le bit de priorité p0 à p255 associé à chaque mot. De façon classique, chaque ligne de bit est double et comporte une ligne de bit non inverseuse BL0 à BL8 et une ligne de bit inverseuse /BLO à /BL8.

La sélection des lignes de mot est assurée par un décodeur d'adresse ADEC recevant l'adresse de mot WAD. Chaque double ligne de bit BL0 à BL8 est reliée à un amplificateur détecteur SA0 à SA8 (sense amplifier) assurant la lecture ou l'écriture d'un bit dans une cellule mémoire de la ligne de mot sélectionnée par le décodeur ADEC.

Les amplificateurs SA0 à SA7 comprennent chacun une entrée/sortie reliée au bus de données DB via l'entrée/ sortie DIO, et reçoivent les mots à enregistrer dans la mémoire tampon ou fournissent des mots lus dans la mémoire tampon. Ils reçoivent directement le signal de lecture SREAD et reçoivent le signal d'écriture SWRITE par l'intermédiaire d'une porte logique AI de type ET, qui reçoit sur une autre entrée un signal d'autorisation ENBL.

L'amplificateur SA8 est réservé à la gestion du bit de priorité et est associé à un circuit de contrôle CONTCT qui est relié à l'entrée/sortie de l'amplificateur SA8, pour enregistrer un bit de priorité ou lire un bit de priorité dans l'une des cellules mémoire supplémentaires, en appliquant à cet amplificateur des commandes spécifiques PWRITE (écrire le bit de priorité ) et PREAD (lire le bit de priorité ). Ainsi les bits de priorité ne circulent pas sur le bus de données, ils restent dans la mémoire tampon et permettent seulement d'identifier les mots externes lors de la sauvegarde de la page cible.

Le circuit CONTCT reçoit le signal MODE et le signal SWRITE, et émet le signal d'autorisation ENBL. Quand le signal MODE est à 1 (mode USER), le circuit CONTCT maintient le signal ENBL à 1, de sorte que la mémoire tampon se lit ou s'écrit comme une mémoire SRAM classique. Toutefois, lorsqu'un mot est écrit dans la mémoire tampon en mode USER, le circuit CONCT fournit un bit de priorité à 0 à l'amplificateur SA8 et lui applique la commande d'écriture PWRITE.

Quand le signal MODE est à 0 (mode BACKUP) et que le circuit CONTCT reçoit le signal d'écriture SWRITE, le circuit CONTCT applique la commande de lecture PREAD à l'amplificateur SA8, puis met le signal d'autorisation ENBL à 1 si le bit de priorité lu par l'amplificateur SA8 est égal à 1 (valeur non active). Dans ce cas, la porte AI devient transparente et le signal d'écriture SWRITE est appliqué aux amplificateurs SA0 à SA7. Si le bit de priorité est à 0, le signal ENBL reste à 0 et le mot présent sur le bus de données n'est pas enregistré dans la mémoire tampon, malgré le fait que le signal SWRITE lui soit appliqué.

La prévision de ces bits de priorité et leur gestion par la mémoire tampon constitue un moyen avantageux permettant de mettre en oeuvre de façon simple le procédé selon l'invention. Il est toutefois à la portée de l'homme de l'art de prévoir d'autres moyens permettant de ne pas écraser les mots externes lors de la sauvegarde de la page cible. Par exemple, le séquenceur peut utiliser un index des adresses des mots externes chargés dans la mémoire tampon et ne pas appliquer l'instruction d'écriture de la mémoire tampon, pendant la lecture de la page cible, lorsque les adresses des mots internes lus dans la page cible figurent dans cet index.

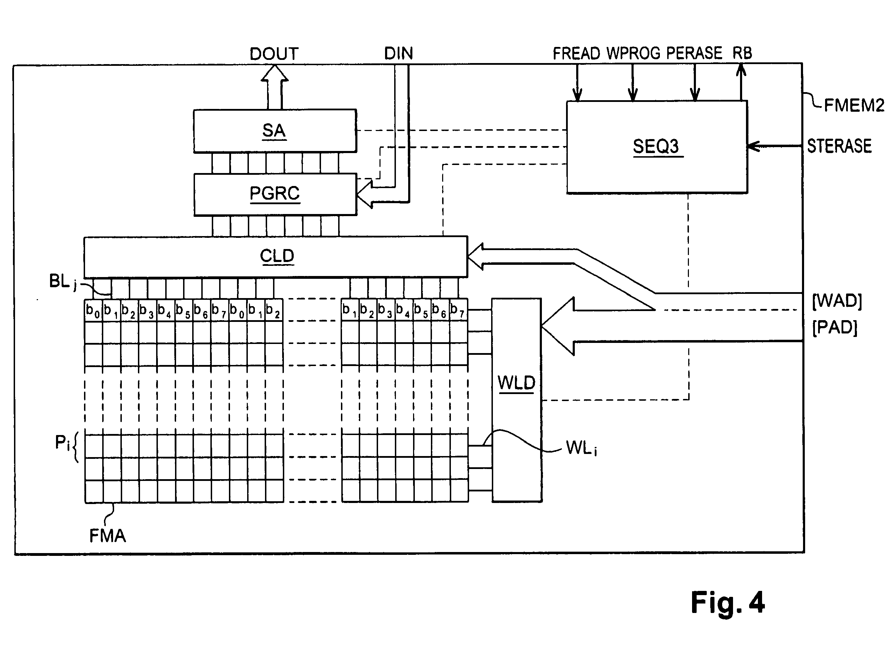

La figure 4 représente schématiquement un exemple d'architecture de mémoire Flash FMEM2, programmable par mot et effaçable par page. La mémoire FMEM2 comprend un plan mémoire Flash, un décodeur de lignes WLD connecté à des lignes de mot $WL_i$ du plan mémoire, un décodeur de colonnes CLD connecté à des lignes de bits $BL_j$ du plan mémoire, ainsi qu'un circuit de lecture SA et un registre tampon de programmation PGRC connectés au décodeur de colonne CLD. Le plan mémoire FMA comprend par exemple 256 secteurs de 256 pages chacun, chaque page comprenant 256 mots, chaque mot comprenant 8 cellules mémoire.

La mémoire FMEM2 reçoit sur son entrée d'adresse une adresse de 24 bits comprenant seize bits de poids fort formant l'adresse de page PAD (adresse de ligne de mot) et huit bits de poids faible formant l'adresse de mot WAD (adresse de colonne). L'adresse PAD est appliquée à un décodeur de lignes de mot WLD et l'adresse WAD est appliquée à un décodeur de colonnes CLD.

Le circuit de lecture SA délivre en parallèle, sur la sortie DOUT de la mémoire FMEM2, les huit bits d'un mot lu dans le plan mémoire. D'autre part, les huit bits d'un mot à programmer sont reçus en parallèle sur l'entrée DIN de la mémoire FMEM2 et sont appliqués au registre tampon de programmation PGRC. Le registre PGRC comprend classiquement une série de verrous de programmation haute tension recevant chacune un bit du mot à programmer et délivrant une haute tension de programmation Vpp lorsque le bit reçu est égal à "0". La tension Vpp, de l'ordre de 5 à 6 V, se propage dans les lignes de bits correspondantes du plan mémoire FMA pour polariser les drains des transistors à programmer tandis qu'une autre tension Vpp de plus forte valeur est appliquée sur les grilles des transistors. La capacité de stockage du registre PGRC est d'un mot et un seul, ici un octet.

Ces divers circuits, registres et décodeurs sont contrôlés et activés par un séquenceur SEQ3. Le séquenceur SEQ3 exécute une opération de lecture d'un octet sur réception du signal FREAD, exécute une opération de programmation d'un octet sur réception du signal WPROG, et exécute une opération d'effacement d'un secteur ou une opération d'effacement d'une page sur réception du signal STERASE ou PERASE. Le séquenceur SEQ3 délivre un signal RB (Ready/Busy) égal à "1" pendant ces opérations, pour la synchronisation de la mémoire FMEM2 avec le séquenceur SEQ2 (fig. 2).

Après l'effacement d'une page, la mémoire FMEM2 ne peut programmer qu'un mot à la fois pour des raisons technologiques rappelées au préambule. Le mot est présenté sur l'entrée DIN et le signal WPROG est appliqué à la mémoire FMEM2.

Le processus de transfert de la mémoire tampon dans la mémoire Flash FMEM2 est donc effectué mot par mot et peut être mis en oeuvre conformément aux indications fournies dans la demande EP 1 111 621. Toutefois, le transfert des mots peut également s'effectuer par groupes de deux voire de quatre mots en parallèle, si la mémoire Flash est prévue à cet effet. Dans ce cas, deux ou trois mémoires tampon sont prévues en parallèle et le nombre de fils du bus de données est augmenté pour comprendre 16 ou 24 bits (si les mots sont des octets) afin de permettre la programmation simultanée de groupe de deux ou trois mots.

## Revendications

1.  Mémoire en circuit intégré comprenant :

    - une mémoire centrale (FMEM2) de type Flash comprenant des cellules mémoire formant des pages (Pi) pouvant recevoir chacune une pluralité de mots (WO-W255),
    - une mémoire tampon (BMEM2), et
    - un séquenceur (SEQ2) pour exécuter une instruction d'enregistrement, dans une page cible (Pi) de la mémoire Flash, d'une suite de mots externes reçue sur une borne d'entrée de la mémoire, en enregistrant tout d'abord la suite de mots externes dans la mémoire tampon (BMEM2),

    **caractérisée en ce que** le séquenceur est agencé pour, après avoir enregistré dans la mémoire tampon la suite de mots externes :

    - enregistrer dans la mémoire tampon des mots internes présents dans la page cible et correspondant, en raison de leur adresse (WAD) dans la page cible, à des emplacements de mots dans la mémoire tampon n'ayant pas reçu de mots externes,
    - effacer la page cible (Pi), et
    - enregistrer dans la page cible effacée les mots présents dans la mémoire tampon, comprenant des mots externes et les mots internes sauvegardés avant effacement de la page cible.

2.  Mémoire selon la revendication 1, dans laquelle la mémoire centrale Flash (FMEM2) est du type effaçable par page, et le séquenceur est agencé pour effacer la page cible sans effacer d'autres pages de la mémoire.

3.  Mémoire selon l'une des revendications 1 et 2, dans laquelle la mémoire tampon (BMEM2) comprend des moyens (SA8, CONTCT) pour ajouter à chaque mot externe (Wj) enregistré dans la mémoire tampon un bit de priorité (pj) ayant une valeur déterminée (0).

4.  Mémoire selon la revendication 3, dans laquelle le séquenceur est agencé pour :

    - lire toute la page cible (Pi),
    - enregistrer dans la mémoire tampon chaque mot interne lu dans la page cible si le bit de priorité (pj) du mot présent dans la mémoire tampon à l'adresse de mot correspondante (WADj) ne présente pas la valeur déterminée (0).

5.  Mémoire selon l'une des revendications 3 et 4, dans laquelle la mémoire tampon comprend des moyens (A1, CONTCT) pour inhiber l'enregistrement d'un mot interne dans la mémoire tampon lorsqu'une commande d'enregistrement (SWRITE) est appliquée à la mémoire tampon, si le bit de priorité (pj) du mot présent dans la mémoire tampon à l'adresse de mot (WADj) visée présente la valeur déterminée.

6.  Mémoire selon l'une des revendications 3 à 5, dans laquelle les bits de priorité présents dans la mémoire tampon sont portés à une valeur logique inverse de la valeur logique déterminée, avant l'enregistrement de la suite de mots externes dans la mémoire tampon.

7.  Mémoire selon la revendication 6, dans laquelle la mémoire tampon est effacée avant l'enregistrement de la suite de mots externes.

8. Mémoire selon l'une des revendications 1 à 7, comprenant un circuit d'interface série/parallèle (ICT) pour recevoir des mots externes à enregistrer dans la mémoire Flash, des adresses (PAD, WAD), et des commandes d'enregistrement, d'effacement ou de lecture de la mémoire Flash.

9. Mémoire selon l'une des revendications 1 à 8, comprenant des registres (WREG, PREG) pour appliquer sur des entrées d'adresse de la mémoire Flash une adresse de la page cible (PAD) et une adresse de mot (WAD), et pour appliquer l'adresse de mot (WAD) sur une entrée d'adresse de la mémoire tampon.

10. Mémoire selon l'une des revendications 1 à 9, dans laquelle les mots présents dans la mémoire tampon sont enregistrés individuellement dans la mémoire Flash ou par groupes de deux ou quatre mots.

11. Procédé d'enregistrement d'une suite de mots externes dans une page cible d'une mémoire (FMEM2) de type Flash comprenant des cellules mémoire formant des pages (Pi) pouvant recevoir chacune une pluralité de mots (W0-W255), comprenant une étape préalable d'enregistrement de la suite de mots externes dans une mémoire tampon (BMEM2),
**caractérisé en ce qu**'il comprend les étapes suivantes :

- après avoir enregistré dans la mémoire tampon la suite de mots externes, enregistrer dans la mémoire tampon des mots internes présents dans la page cible et correspondant en raison de leur adresse (WAD) dans la page cible à des emplacements de mots dans la mémoire tampon n'ayant pas reçu de mots externes,
- effacer la page cible (Pi), et
- enregistrer dans la page cible effacée les mots présents dans la mémoire tampon, comprenant des mots externes et les mots internes sauvegardés avant effacement de la page cible.

12. Procédé selon la revendication 11, dans lequel l'effacement de la page cible (Pi) est effectué sans effacer d'autres pages de la mémoire Flash (FMEM2).

13. Procédé selon l'une des revendications 11 et 12, comprenant une étape consistant à ajouter un bit de priorité (pj) ayant une valeur déterminée à chaque mot externe (Wj) enregistré dans la mémoire tampon (BMEM2).

14. Procédé selon la revendication 13, comprenant les étapes suivantes :

- lire toute la page cible (Pi),
- enregistrer dans la mémoire tampon un mot interne lu dans la page cible si le bit de priorité (pj) du mot présent dans la mémoire tampon à l'adresse de mot correspondante (wADj) ne présente pas la valeur déterminée (0).

15. Procédé selon l'une des revendications 13 et 14, dans lequel les bits de priorité (p0-p255) présents dans la mémoire tampon sont portés à une valeur logique inverse de la valeur logique déterminée, avant l'enregistrement de la suite de mots externes dans la mémoire tampon.

16. Procédé selon l'une des revendications 11 à 15, comprenant l'application, sur des entrées d'adresse de la mémoire Flash, d'une adresse de la page cible (PAD) et d'une adresse de mot (WAD), et l'application de l'adresse de mot (WAD) sur une entrée d'adresse de la mémoire tampon.

17. Procédé selon l'une des revendications 11 à 16, dans lequel les mots présents dans la mémoire tampon sont enregistrés dans la mémoire Flash par groupes de mots comprenant deux ou quatre mots.

**Claims**

1. A memory in integrated circuit comprising:

- a central Flash-type memory (FMEM2) comprising memory cells forming pages (Pi) each capable of receiving a plurality of words (W0-W255),
- a buffer memory (BMEM2), and
- a sequencer (SEQ2) for executing an instruction for recording, in a target page (Pi) of the Flash memory, a series of external words received at an input terminal of the memory, by first of all recording the series of external words in the buffer memory (BMEM2),

**characterized in that** the sequencer is arranged for, after recording the series of external words in the buffer memory:

- recording, in the buffer memory, internal words present in the target page and corresponding, due to their address (WAD) in the target page, to locations of words in the buffer memory that have not received any external words,
- erasing the target page (Pi), and
- recording, in the erased target page, the words present in the buffer memory, comprising external words and the internal words recorded before erasing the target page.

2. Memory according to claim 1, wherein the central Flash memory (FMEM2) is of the page-erasable type, and the sequencer is arranged for erasing the target page without erasing other pages of the memory.

3. Memory according to one of claims 1 and 2, wherein the buffer memory (BMEM2) comprises means (SA8, CONTCT) for adding to each external word (Wj) recorded in the buffer memory a priority bit (pj) having a determined value (0).

4. Memory according to claim 3, wherein the sequencer is arranged for:

- reading the entire target page (Pi),
- recording, in the buffer memory, each internal word read in the target page if the priority bit (pj) of the word present in the buffer memory at the corresponding word address (WADj) does not have the determined value (0).

5. Memory according to one of claims 3 and 4, wherein the buffer memory comprises means (A1, CONTCT) for inhibiting the recording of an internal word in the buffer memory when a record command (SWRITE) is applied to the buffer memory, if the priority bit (pj) of the word present in the buffer memory at the word address (WADj) targeted has the determined value.

6. Memory according to one of claims 3 to 5, wherein the priority bits present in the buffer memory are taken to a logic value that is the opposite of the determined logic value, before the series of external words is recorded in the buffer memory.

7. Memory according to claim 6, wherein the buffer memory is erased before the series of external words is recorded.

8. Memory according to one of claims 1 to 7, comprising a serial/parallel interface circuit (ICT) for receiving external words to be recorded in the Flash memory, addresses (PAD, WAD), and commands for recording, erasing or reading the Flash memory.

9. Memory according to one of claims 1 to 8, comprising registers (WREG, PREG) for applying, to address inputs of the Flash memory, one address of the target page (PAD) and one word address (WAD), and for applying the word address (WAD) to an address input of the buffer memory.

10. Memory according to one of claims 1 to 9, wherein the words present in the buffer memory are recorded individually in the Flash memory or by groups of two or four words.

11. A method for recording a series of external words in a target page of a Flash-type memory (FMEM2) comprising memory cells forming pages (Pi) each capable of receiving a plurality of words (W0-W255), comprising a prior step of recording the series of external words in a buffer memory (BMEM2),
**characterized in that** it comprises the following steps:

- after recording the series of external words in the buffer memory, recording, in the buffer memory, internal words present in the target page and corresponding, due to their address (WAD) in the target page, to locations of words in the buffer memory that have not received any external words,
- erasing the target page (Pi), and
- recording, in the erased target page, the words present in the buffer memory, comprising external words and the internal words recorded before erasing the target page.

**12.** Method according to claim 11, wherein the target page (Pi) is erased without erasing other pages of the Flash memory (FMEM2).

**13.** Method according to one of claims 11 and 12, comprising a step of adding a priority bit (pj) having a determined value to each external word (Wj) recorded in the buffer memory (BMEM2).

**14.** Method according to claim 13, comprising the following steps:

- reading the entire target page (Pi),
- recording, in the buffer memory, an internal word read in the target page if the priority bit (pj) of the word present in the buffer memory at the corresponding word address (WADj) does not have the determined value (0).

**15.** Method according to one of claims 13 and 14, wherein the priority bits (p0-p255) present in the buffer memory are taken to a logic value that is the opposite of the determined logic value, before recording the series of external words in the buffer memory.

**16.** Method according to one of claims 11 to 15, comprising the application, to address inputs of the Flash memory, of an address of the target page (PAD) and of a word address (WAD), and the application of the word address (WAD) to an address input of the buffer memory.

**17.** Method according to one of claims 11 to 16, wherein the words present in the buffer memory are recorded in the Flash memory by groups of words comprising two or four words.

**Patentansprüche**

**1.** Speicher in integrierter Schaltung, umfassend:

- einen zentralen Speicher (FMEM2) vom Typ Flash-Speicher, der Speicherzellen aufweist, die Seiten (Pi) bilden, die jeweils eine Vielzahl von Wörtern (W0- W255) aufnehmen können,
- einen Pufferspeicher (BMEM2) und
- eine Folgesteuerungseinheit (SEQ2) zur Ausführung einer Anweisung zur Speicherung in einer Zielseite (Pi) des Flash-Speichers einer Folge externer Wörter, die an einem Eingangsanschluss des Speichers empfangen wurde, indem zunächst die Folge von externen Wörtern im Pufferspeicher (BMEM2) gespeichert wird,

**dadurch gekennzeichnet, dass** die Folgesteuerungseinheit dafür eingerichtet ist, nachdem sie die Folge externer Wörter im Pufferspeicher gespeichert hat:

- im Pufferspeicher interne Wörter zu speichern, die sich in der Zielseite befinden und aufgrund ihrer Adresse (WAD) in der Zielseite Stellen von Wörtern im Pufferspeicher entsprechen, die keine externen Wörter empfangen haben,
- die Zielseite (Pi) zu löschen und
- in der gelöschten Zielseite die Wörter zu speichern, die sich im Pufferspeicher befinden, externe Wörter umfassend und die internen Wörter, die vor dem Löschen der Zielseite gesichert wurden.

**2.** Speicher nach Patentanspruch 1, in dem der zentrale Flash-Speicher (FMEM2) vom seitenweise löschbaren Typ ist und die Folgesteuerungseinheit derart eingerichtet ist, dass sie die Zielseite löscht, ohne andere Seiten des Speichers zu löschen.

**3.** Speicher nach einem der Patentansprüche 1 und 2, in dem der Pufferspeicher (BMEM2) Mittel (SA8, CONTCT) aufweist, um jedem im Pufferspeicher gespeicherten externen Wort (Wj) ein Prioritätsbit (pj) hinzuzufügen, das einen festgelegten Wert (0) hat.

**4.** Speicher nach Patentanspruch 3, in dem die Folgesteuerungseinheit dafür eingerichtet ist:

- die gesamte Zielseite (Pi) zu lesen,
- im Pufferspeicher jedes in der Zielseite gelesene interne Wort zu speichern, wenn das Prioritätsbit (pj) des im Pufferspeicher an der entsprechenden Adresse (WADj) anwesenden Wortes nicht den festgelegten Wert (0) hat.

**5.** Speicher nach einem der Patentansprüche 3 und 4, in dem der Pufferspeicher Mittel (A1, CONTCT) aufweist, um die Speicherung eines internen Wortes im Pufferspeicher zu verhindern, wenn eine Speicheranweisung (SWRITE) an den Pufferspeicher angelegt wird, wenn das Prioritätsbit (pj) des im Pufferspeicher an der betreffenden Wortadresse (WADj) anwesenden Wortes den festgelegten Wert aufweist.

**6.** Speicher nach einem der Patentansprüche 3 bis 5, in dem die im Pufferspeicher anwesenden Prioritätsbits vor Speicherung der Folge externer Wörter in den Pufferspeicher auf den dem festgelegten Wahrheitswert entgegengesetzten Wahrheitswert gesetzt werden.

**7.** Speicher nach Patentanspruch 6, in dem der Pufferspeicher vor Speicherung der Folge von externen Wörtern gelöscht wird.

**8.** Speicher nach einem der Patentansprüche 1 bis 7, eine seriell/parallel-Schnittstellenschaltung (ICT) umfassend, um im Flash-Speicher zu speichernde externe Wörter, Adressen (PAD, WAD) und Befehle zur Speicherung, Löschung oder zum Lesen des Flash-Speichers zu empfangen.

**9.** Speicher nach einem der Patentansprüche 1 bis 8, Register (WREG, PREG) umfassend, um an Adresseneingänge des Flash-Speichers eine Adresse der Zielseite (PAD) und eine Wortadresse (WAD) anzulegen und um die Wortadresse (WAD) an einen Adresseneingang des Pufferspeichers anzulegen.

**10.** Speicher nach einem der Patentansprüche 1 bis 9, in dem die im Pufferspeicher anwesenden Wörter einzeln oder in Gruppen von zwei oder vier Wörtern in den Flash-Speicher gespeichert werden.

**11.** Verfahren zur Speicherung einer Folge von externen Wörtern in eine Zielseite eines Speichers (FMEM2) vom Typ Flash-Speicher, der Speicherzellen aufweist, die Seiten (Pi) bilden, die jeweils eine Vielzahl von Wörtern (W0-W255) aufnehmen können, zunächst einen Schritt der Speicherung der Folge externer Wörter in einen Pufferspeicher (BMEM2) umfassend,
**dadurch gekennzeichnet, dass** es die folgenden Schritte umfasst:

- nachdem die Folge externer Wörter im Pufferspeicher gespeichert wurde, im Pufferspeicher interne Wörter zu speichern, die sich in der Zielseite befinden und aufgrund ihrer Adresse (WAD) in der Zielseite Stellen von Wörtern im Pufferspeicher entsprechen, die keine externen Wörter empfangen haben,
- die Zielseite (Pi) zu löschen und
- in der gelöschten Zielseite die Wörter zu speichern, die sich im Pufferspeicher befinden, externe Wörter umfassend und die internen Wörter, die vor dem Löschen der Zielseite gesichert wurden.

**12.** Verfahren nach Patentanspruch 11, in dem das Löschen der Zielseite (Pi) erfolgt, ohne andere Seiten des Flash-Speichers (FMEM2) zu löschen.

**13.** Verfahren nach einem der Patentansprüche 11 und 12, einen Schritt umfassend, in dem ein Prioritätsbit (pj), das einen festgelegten Wert hat, jedem externen Wort (Wj) hinzugefügt wird, das im Pufferspeicher (BMEM2) gespeichert ist.

**14.** Verfahren nach Patentanspruch 13, die folgenden Schritte umfassend:

- die gesamte Zielseite (Pi) lesen,
- im Pufferspeicher ein in der Zielseite gelesenes internes Wort zu speichern, wenn das Prioritätsbit (pj) des im Pufferspeicher an der entsprechenden Adresse (WADj) anwesenden Wortes nicht den festgelegten Wert (0) hat.

**15.** Verfahren nach einem der Patentansprüche 13 und 14, in dem die im Pufferspeicher anwesenden Prioritätsbits (p0 - p255) vor der Speicherung der Folge externer Wörter in den Pufferspeicher auf den dem festgelegten Wahrheitswert entgegengesetzten Wahrheitswert gesetzt werden.

**16.** Verfahren nach einem der Patentansprüche 11 bis 15, das Anlegen einer Adresse der Zielseite (PAD) und einer Wortadresse (WAD) an Adresseneingänge des Flash-Speichers umfassend und das Anlegen der Wortadresse (WAD) an einen Adresseneingang des Pufferspeichers.

**17.** Verfahren nach einem der Patentansprüche 11 bis 16, in dem die im Pufferspeicher anwesenden Wörter in Wortgruppen von zwei oder vier Wörtern im Flash-Speicher gespeichert werden.

**Fig. 1**

Fig. 2

Fig. 3

EP 1 486 986 B1

Fig. 4

**EP 1 486 986 B1**

## RÉFÉRENCES CITÉES DANS LA DESCRIPTION

**Documents brevets cités dans la description**

- EP 1111621 A

- WO 0241322 A